# FASCICULE DE BREVET EUROPEEN

(11) **EP 2 654 105 B1**
(45) Date de publication et mention de la délivrance du brevet: **18.06.2014**
(21) Numéro de dépôt: 13164038.5
(22) Date de dépôt: 17.04.2013
(51) Int. Cl.: H01M 2/12, H01M 10/48, H01M 2/34, H05K 1/02, H01M 2/02, H01M 10/0525, H01M 10/34, H01M 10/42, H01M 2/10

(54) **Système et procédé de détection de désoperculation pour un accumulateur étanche**
Verfahren und System zum Erfassen der Öffnung eines Dichtelements für einen abgedichteten Akkumulator
System and method for detecting the opening of a seal member in a sealed accumulator

(30) Priorité: 18.04.2012 FR 1253560
(43) Date de publication de la demande: 23.10.2013
(73) Titulaire: SAFT GROUPE SA, 93170 Bagnolet (FR)
(72) Inventeur: Guidal, Laurent, 86190 Latille (FR); Susset, Pascal, 86340 Nieuil l'Espoir (FR); Vigier, Nicolas, 86000 Poitiers (FR)
(74) Mandataire: Hirsch & Associés

(56) Documents cités:
- FR-A1- 2 020 290
- FR-A1- 2 718 290
- FR-A1- 2 873 495
- JP-A- 2005 322 471
- JP-A- 2010 205 471
- US-A1- 2009 111 003

## Description

La présente invention concerne un système et un procédé de détection de désoperculation pour un accumulateur étanche. L'invention concerne également un ensemble comportant un accumulateur étanche et un tel système de détection ainsi qu'un dispositif comportant une pluralité d'ensembles de ce type.

Une définition du terme « désoperculation » sera donnée dans la suite de la description.

L'invention se rapporte au domaine des accumulateurs étanches, en particulier les accumulateurs de type lithium-ion.

Un accumulateur étanche ou générateur électrochimique étanche (ces deux termes étant équivalents, on utilisera le terme d'accumulateur dans la présente description) comprend de façon connue en soi un conteneur contenant un faisceau électrochimique, lequel faisceau comporte une alternance d'électrodes positives et négatives encadrant des séparateurs. Le faisceau est imprégné d'électrolyte. Chaque électrode est composée d'un collecteur de courant métallique supportant sur au moins une de ses faces une matière électrochimiquement active. L'électrode est connectée électriquement à une borne de sortie de courant qui assure la continuité électrique entre l'électrode et l'application extérieure à laquelle l'accumulateur est associé. Le faisceau d'électrodes est disposé dans le conteneur fermé de manière étanche par un couvercle.

L'utilisation d'un accumulateur étanche hors des conditions nominales, comme par exemple lors d'une surcharge accidentelle, d'un court-circuit, ou lors d'une exposition à une température supérieure à la température maximale de fonctionnement, crée un risque d'explosion. En effet, de telles situations entraînent des réactions de l'électrochimie qui génèrent des gaz dans le conteneur de l'accumulateur. L'accumulation de ces gaz entraîne une augmentation de la pression interne de l'accumulateur, qui peut conduire à un éclatement violent du conteneur et à la projection de composés chimiques nocifs et corrosifs pour l'environnement et les personnes situées à proximité.

Des dispositifs de sécurité existent, qui évitent l'accumulation des gaz à l'intérieur du conteneur d'un accumulateur étanche et permettent leur évacuation lorsque la pression interne excède une valeur prédéterminée. Certains de ces dispositifs possèdent également une fonction de coupe-circuit, c'est-à-dire qu'ils sont aussi aptes à isoler électriquement et de façon irréversible, les appareils connectés à l'accumulateur.

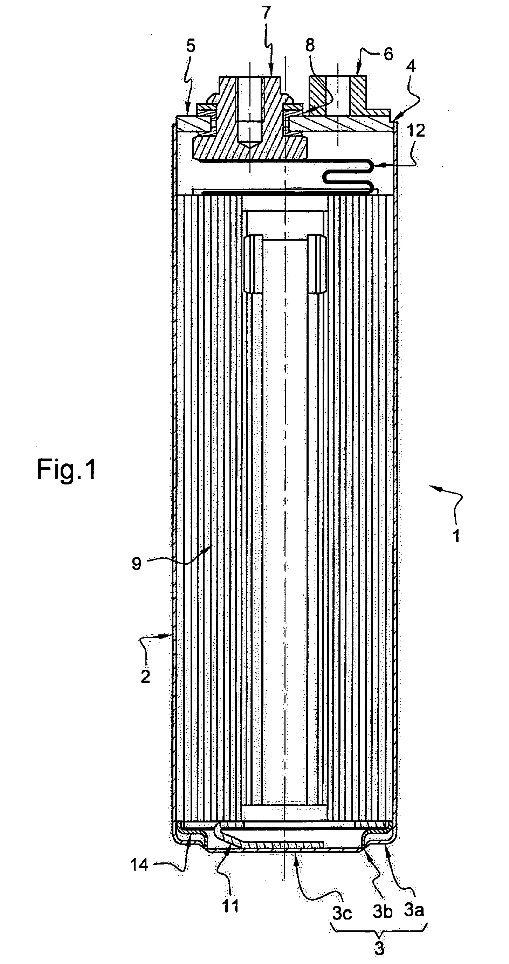

Le document FR-A-2 873 495 décrit un accumulateur comprenant un dispositif de sécurité combinant la fonction de soupape de sécurité et celle de coupe-circuit. Une vue en coupe longitudinale de cet accumulateur est représentée Figure 1.

L'accumulateur 1 comprend un conteneur 2 présentant une paroi latérale cylindrique obturée à l'une de ses extrémités par un fond 3 et à l'extrémité opposée 4 par un couvercle 5. Le fond 3 est formé de trois parties : une partie périphérique 3a reliée électriquement à la paroi latérale, un opercule 3c et un amincissement 3b reliant l'opercule à la partie périphérique.

L'accumulateur comporte en outre une alternance d'électrodes positives et négatives respectivement reliées à des bornes de sortie de courant 6, 7 et un faisceau électrochimique 9. Les électrodes et le faisceau électrochimique sont disposés dans le conteneur 2.

Une première connexion plane 11 raccorde l'électrode positive du faisceau électrochimique 9 à la paroi du fond du conteneur, la paroi du fond du conteneur étant électriquement conductrice avec le couvercle 5. Sur le couvercle est soudée la borne positive de sortie de courant 6.

Une seconde connexion plane 12 raccorde l'électrode négative du faisceau à la borne négative de sortie de courant 7. La borne négative de sortie de courant 7 passe à travers le couvercle 5. Un joint 8 isole électriquement la borne négative de sortie de courant 7 du couvercle 5.

Un joint en forme d'anneau 14 est placé entre le faisceau électrochimique et le fond du conteneur. Il sert d'isolant électrique afin d'empêcher un contact électrique entre la tranche d'une électrode négative du faisceau et la paroi du conteneur reliée à la borne positive, ce qui occasionnerait un court-circuit après que le dispositif de sécurité ait été activé.

Une déchirure de l'amincissement 3b permet de désolidariser l'opercule 3c de la partie périphérique 3a et est adaptée pour interrompre la conduction électrique entre les électrodes d'une polarité et leur borne de sortie de courant associée en déconnectant l'opercule 3c de la partie périphérique 3a. Le faisceau électrochimique 9 est en appui sur la pièce de connexion 11 située dans le fond 3 du conteneur 2.

Lors d'une surpression à l'intérieur du conteneur 2, la partie amincie 3b se déchire et le faisceau en appui sur l'opercule 3c par le biais de la pièce de connexion 11 se déplace vers le fond 3 du conteneur déchirant la totalité de la partie amincie afin d'assurer la coupure électrique entre l'électrode positive du faisceau électrochimique et le couvercle du conteneur.

Ce phénomène est appelé « désoperculation » ou *« venting* » en anglais. On entend donc par « désoperculation » la désolidarisation de l'opercule 3c du reste du conteneur 2 lors de la surpression de gaz à l'intérieur de ce conteneur.

L'opercule 3c et son agencement dans le conteneur 2 sont dimensionnés pour permettre cette désolidarisation à une pression de gaz donnée. A titre d'exemple, on dimensionne ces pièces de manière à ce que l'opercule 3c se désolidarise pour des pressions supérieures ou égales à 8 bars.

Ainsi une surpression à l'intérieur du conteneur entraîne une coupure électrique entre les deux électrodes engendrant une tension nulle aux bornes de l'accumulateur.

Or, d'autres causes peuvent engendrer le même effet de perte de la tension totale aux bornes de l'accumulateur, comme par exemple une rupture interne de la connexion plane 12. De même si un fusible ou une soudure est hors-service.

Un inconvénient de ce type d'accumulateur est qu'il ne permet pas de connaître la cause de l'apparition d'une tension nulle aux bornes de l'accumulateur. On recherche donc un système de détection pour un accumulateur étanche adapté pour détecter de manière spécifique quand une surpression dans le conteneur de l'accumulateur se produit et permettant ainsi de mettre en évidence de manière fiable quand une tension nulle aux bornes de l'accumulateur est due à une surpression.

De tels systèmes sont néanmoins en parti connus de l'état de la technique. On citera notamment :
- Le document FR 2 718 290 A1 divulgue un système de détection de désoperculation dont le fonctionnement est basé sur la rupture d'une couche de laque conductrice et l'ouverture du chemin électrique associé. Aucun circuit imprimé n'est mentionné.
- Le document US 2009/111003 A1 divulgue un accumulateur comprenant un circuit imprimé et comportant une partie sécable qui se rompt lors de la désoperculation. Le circuit imprimé est localisé à l'intérieur de l'enveloppe de l'accumulateur et ne comporte pas de charnière.
- Le document JP 2005 322471 A divulgue un système de détection de désoperculation dont le fonctionnement est basé sur la rupture d'un chemin conducteur intégré dans une valve et l'ouverture du chemin électrique associé.

Le problème que la présente invention se propose de résoudre peut donc être formulé comme proposer une solution alternative permettant une détection fiable de la désoperculation d'un accumulateur étanche.

A cet effet et selon un premier aspect, la présente invention propose un système de détection de désoperculation pour un accumulateur étanche, l'accumulateur étanche comportant un conteneur comprenant un opercule adapté pour se désolidariser du reste du conteneur et pour se déplacer lors d'une surpression de gaz à l'intérieur du conteneur pour permettre la désoperculation de l'accumulateur étanche, le système de détection comprenant une plaque de circuit imprimé comprenant :
- une portion centrale délimitée par un pourtour destinée à être située en regard de l'opercule,
- une portion périphérique entourant la portion centrale et reliée à ladite portion centrale par des moyens de liaison consistant en :
   ◆ une charnière adaptée pour se plier lors du déplacement de l'opercule, et
   ◆ au moins une partie sécable adaptée pour se rompre lors du déplacement de l'opercule,
- une piste électrique reliant la portion périphérique à la portion centrale en passant par la charnière et par au moins une partie sécable, la piste électrique étant adaptée à son rompre lors de la rupture de la partie sécable lors du déplacement de l'opercule.

Un tel système de désoperculation pour un accumulateur étanche permet ainsi de détecter quand une surpression a lieu dans le conteneur de l'accumulateur. Cette détection est réalisée grâce à un dispositif actionné mécaniquement sans l'utilisation de moyens potentiels électroniques du type détecteurs de pression ou de gaz et ainsi, sans consommation d'énergie particulièrement inutile dans les conditions nominales d'utilisation de l'accumulateur.

Ce système permet en outre de discriminer simplement, rapidement et de manière fiable la cause d'une perte de tension aux bornes de l'accumulateur en identifiant quand il s'agit d'une surpression ou non.

Dans le cadre de la présente invention, on entend par :
- « désolidarisation » l'action de séparation au moins partielle d'une première pièce d'une deuxième pièce à laquelle la première pièce était reliée avant la désolidarisation ; et
- « plaque de circuit imprimé » (PCB pour « *printed circuit board* » en anglais) une plaque constituée principalement d'une résine époxy renforcée de fibre de verre pouvant être utilisée comme support pour permettre de relier électriquement des composants électroniques entre eux ; une telle plaque est en général préalablement doublée d'une fine couche de cuivre sur un ou ses deux côtés et recouverte d'une couche de vernis photosensible et ces couches sont traitées de manière à conserver des pistes en cuivre dans des endroits désirés ; les couches de cuivre sont gravées par procédé chimique pour obtenir un ensemble de pistes.

Suivant des modes de réalisation préférés, le système de désoperculation pour un accumulateur selon l'invention comprend une ou plusieurs des caractéristiques suivantes, prises séparément ou en combinaison :
- la portion centrale et la portion périphérique sont reliées en continuité de matière par les moyens de liaison sur une distance inférieure ou égale à 25 % du pourtour de la portion centrale ;
- la charnière et la ou les parties sécables sont espacées angulairement d'un angle sensiblement égale à 180° par rapport au centre géométrique de la portion centrale ;
- un pointillé de découpe forme la charnière selon une ligne moyenne droite reliant les deux extrémités de la charnière ;
- un pointillé de découpe forme la ou chaque partie sécable ;
- le pointillé de découpe formant la charnière et le pointillé de découpe formant la partie sécable sont perpendiculaires l'un par rapport à l'autre ;
- la forme de la portion centrale est circulaire ou hexagonale ;
- le système de détection comporte une entretoise destinée à assurer le contact entre l'opercule du conteneur et la portion centrale de la plaque de circuit imprimé ;
- l'épaisseur de la plaque de circuit imprimé est comprise entre 0,1 et 2 mm ;
   et
- la portion centrale comporte un disque prolongé par une languette, la languette comportant deux parties sécables et étant reliée en continuité de matière à la partie périphérique, la piste électrique passant par la languette.

Selon un deuxième aspect, l'invention concerne également un ensemble comportant un accumulateur étanche et un système de détection tel que décrit ci-dessus, dans lequel l'accumulateur étanche comporte un conteneur comprenant un élément mobile adapté à se déplacer lors d'une surpression de gaz à l'intérieur du conteneur, la portion centrale du système de détection étant fixé en regard de l'élément mobile du conteneur.

Suivant des modes de réalisation préférés, l'ensemble selon l'invention comporte une membrane déformable adaptée pour se déformer lors d'une surpression de gaz à l'intérieur du conteneur, cette déformation provoquant la désolidarisation de l'opercule du reste du conteneur.

Selon un troisième aspect, l'invention concerne également un dispositif comportant au moins deux ensembles tels que définis ci-avant, dans lequel les accumulateurs étanches des ensembles sont connectés électriquement en parallèle, les systèmes de détection des ensembles sont connectés électriquement en série, les plaques de circuit imprimés des systèmes de détection formant une unique plaque commune.

Selon un quatrième aspect, l'invention concerne également un procédé de détection par un système de détection de désoperculation pour un accumulateur étanche tel que décrit précédemment, l'accumulateur étanche comportant un conteneur comprenant un opercule adapté pour se désolidariser du reste du conteneur et pour se déplacer lors d'une surpression de gaz à l'intérieur du conteneur, le procédé comportant les étapes suivantes :
- déplacement mécanique de l'opercule lors d'une surpression à l'intérieur du conteneur, et
- simultanément pliage de la charnière et rupture de la partie sécable lors du déplacement de l'opercule entraînant une rupture de la piste électrique.

Suivant des modes de réalisation préférés du procédé de désoperculation selon l'invention, la rupture de la piste électrique déclenche un signal d'alerte informant de la rupture de la piste électrique.

D'autres caractéristiques et avantages de l'invention apparaîtront à la lecture de la description qui suit d'un mode de réalisation préféré de l'invention, donnée à titre d'exemple et en référence aux dessins annexés :
- la figure 1 est un schéma synoptique d'une vue en coupe d'un accumulateur étanche comportant un dispositif de sécurité selon l'art antérieur ;
- la figure 2 est un schéma synoptique d'une vue partielle en coupe longitudinale d'un premier mode de réalisation d'un ensemble comportant un accumulateur et un système de détection selon l'invention dans des conditions nominales de fonctionnement de l'accumulateur ;
- la figure 3 est un schéma synoptique d'une vue partielle en coupe longitudinale d'un deuxième mode de réalisation d'un ensemble comportant un accumulateur et un système de détection selon l'invention dans des conditions nominales de fonctionnement de l'accumulateur ;
- la figure 4 est un schéma synoptique d'une vue partielle en coupe longitudinale d'un troisième mode de réalisation d'un ensemble comportant un accumulateur et un système de détection selon l'invention dans des conditions nominales de fonctionnement de l'accumulateur ;
- la figure 5 est un schéma synoptique d'une vue partielle en coupe longitudinale d'un ensemble de la figure 4 après rupture de l'amincissement et détachement de l'opercule du fond du conteneur ;
- la figure 6 est un schéma bloc illustrant un procédé de détection de désoperculation pour un accumulateur selon l'invention ;
- la figure 7 est un schéma synoptique d'un système de détection de désoperculation pour un accumulateur selon l'invention ;
- la figure 8 est un schéma synoptique d'une pluralité de systèmes de détection comportant une plaque commune d'un dispositif selon l'invention ;
- la figure 9 est un schéma électrique équivalent d'un dispositif comportant deux ensembles selon l'invention dans des conditions nominales de fonctionnement ; et
- la figure 10 est un schéma électrique équivalent du dispositif de la figure 9 en fonctionnement et après une panne d'un des deux accumulateurs.

Sur les différentes figures, les éléments analogues sont désignés par des références identiques. En outre, les différents éléments ne sont pas nécessairement représentés à l'échelle afin de présenter une vue permettant de faciliter la compréhension de l'invention.

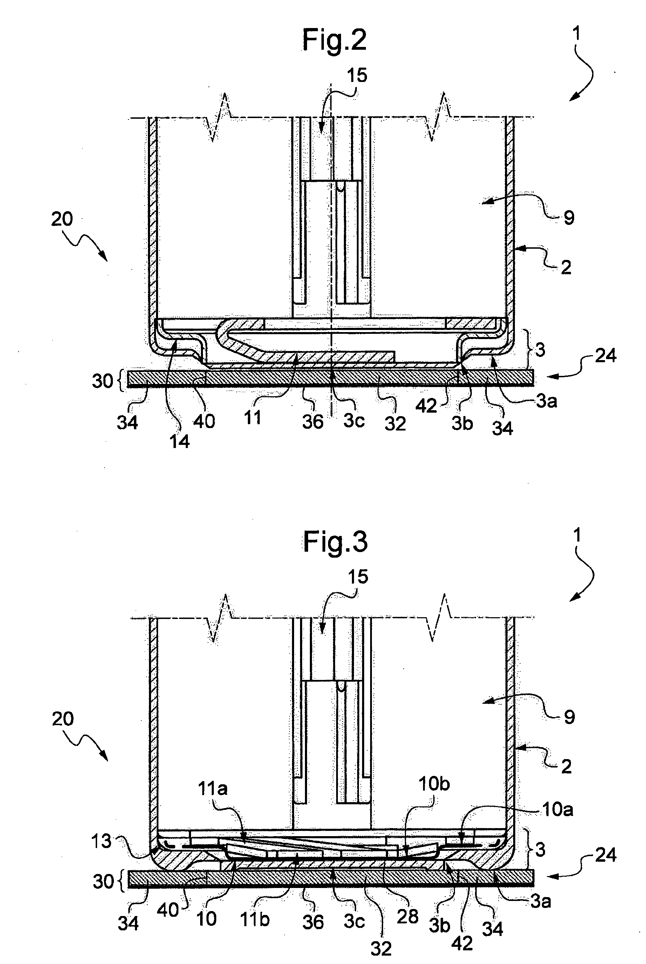

Un système de détection selon l'invention représenté en figure 2 est agencé de manière à coopérer avec un accumulateur étanche. La figure 2 illustre un premier mode de réalisation d'un ensemble 20 comportant un accumulateur étanche 1 et un système de détection 24.

L'accumulateur étanche 1 comporte un conteneur 2 comprenant un élément mobile. L'élément mobile est adapté pour se désolidariser du reste du conteneur et pour se déplacer, par exemple de quelques millimètres, lors d'une surpression de gaz à l'intérieur du conteneur 2 et ainsi pour permettre la désoperculation de l'accumulateur étanche 1.

Dans les différents modes de réalisation décrits ci-après, les formats du conteneur 2 et de l'élément mobile sont cylindriques mais il est entendu que l'invention s'applique à d'autres formats de conteneurs et/ou d'éléments mobiles, tels que le format parallélépipédique (ou prismatique).

En outre, dans la suite de la description, le conteneur 2 de l'accumulateur étanche 1 présente une paroi latérale 2 obturée par un fond 3 à l'une de ses extrémités. La paroi du fond du conteneur comporte une partie périphérique 3a reliée à la paroi latérale, un opercule 3c et une partie fragilisée 3b autour de l'opercule joignant l'opercule à la partie périphérique. L'opercule 3c forme l'élément mobile adapté à se déplacer lors d'une surpression de gaz à l'intérieur du conteneur.

Dans les différents modes de réalisation décrits ci-après, l'élément mobile ou opercule 3c est agencé dans le fond du conteneur mais il est entendu que l'invention s'applique à d'autres éléments mobiles ou opercules agencés par exemple dans un couvercle ou sur une paroi latérale du conteneur.

Le système de détection de désoperculation 24 pour un tel accumulateur étanche comprend une plaque de circuit imprimé 30 fixée au conteneur 2 à une distance de fixation maximale inférieure à la distance limite de déplacement de l'opercule 3c. De préférence, la plaque de circuit imprimé 30 est fixée au conteneur à une distance inférieure ou égale à 70% de la distance limite ou maximale de déplacement de l'opercule 3c. On entend par distance de fixation la distance moyenne, selon l'axe de déplacement de l'opercule 3c, entre les plans définis d'une part par l'opercule 3c et d'autre part par la plaque de circuit imprimé 30.

Par exemple, la plaque de circuit imprimé 30 est en contact avec et accolée à l'opercule 3c.

A cet effet, le système de détection 24 comporte des moyens de fixation de la plaque de circuit imprimé 30 au conteneur 2 à une distance de fixation prédéterminée dépendant de la distance de déplacement de l'élément mobile.

La plaque de circuit imprimé 30 est en matériau isolant. Elle comporte une portion centrale 32, une portion périphérique 34 entourant la portion centrale 32 et une piste électrique 36.

La portion centrale 32 est délimitée par un pourtour 38 sensiblement circulaire et elle est destinée à être située en regard de l'opercule 3c.

La portion centrale 32 a sensiblement les mêmes dimensions que l'accumulateur 1. Le rapport entre le diamètre moyen de la portion centrale et le diamètre moyen de l'élément mobile est compris entre 0,5 et 2. Par exemple, pour un accumulateur de diamètre 54 mm, la portion centrale a un diamètre sensiblement égal à 54 mm pour un opercule de diamètre 43 mm.

Bien entendu, l'invention s'applique à d'autres formes de contour et d'autres formes de portion centrale, tels que les formes polygonales comme par exemple une forme hexagonale.

La portion périphérique 34 est reliée à ladite portion centrale 32 par des moyens de liaison consistant en une charnière 40 et au moins une partie sécable 42.

De préférence, la portion centrale 32 et la portion périphérique 34 sont reliées en continuité de matière par les moyens de liaison sur une distance inférieure ou égale à 25 % du pourtour de la portion centrale 32.

Le reste de la distance du pourtour de la portion centrale 32 peut-être un amincissement ou de façon privilégiée, car plus facile à réaliser, une zone découpée.

La charnière 40 est adaptée pour se plier lors du déplacement de l'opercule 3c.

Par exemple, un pointillé de découpe forme la charnière 40 selon une ligne moyenne droite reliant les deux extrémités de la charnière 40. L'espacement et la taille des trous formant le pointillé de découpe de la charnière est réalisé de sorte que la charnière 40 se plie lors du déplacement de l'opercule 3c, de préférence sans se rompre. Par exemple, les trous du pointillé formant la charnière 40 ont un diamètre de 0,35 mm, ils sont agencés en groupes. Deux centres consécutifs d'un même groupe sont espacés de 0,25 mm et deux centres consécutifs de deux groupes distincts et consécutifs sont espacés de 1,15 mm.

La ou chaque partie sécable 42 est adaptée à se rompre lors du déplacement de l'opercule 3c.

Par exemple, un pointillé de découpe forme chaque partie sécable 42, l'espacement et la taille des trous formant le pointillé de découpe d'une partie sécable étant réalisé de sorte que la partie sécable 42 se rompe lors du déplacement de l'opercule 3c. Par exemple, les trous du pointillé formant la partie sécable 42 ont un diamètre de 0,35 mm et sont espacés de 1,15 mm

En outre, la charnière et la ou les parties sécables sont espacées angulairement d'un angle sensiblement égal à 180°, c'est-à-dire égal à 180° ± 20°.

La piste électrique 36 relie la portion périphérique 34 à la portion centrale 32 en passant à la fois par la charnière 40 et par au moins une partie sécable 42.

La piste électrique 36 comporte deux extrémités situées chacune sur la portion périphérique 34 connectées chacune à une borne. La première borne est polarisée à une tension prédéfinie, par exemple 12 V et la seconde borne est connectée à une masse du circuit électrique, soit 0 V. Ainsi, le circuit électrique comportant les deux bornes polarisées et la piste électrique est adapté pour piloter un système du type relais.

La piste électrique 36 est par exemple en cuivre.

De plus, la piste électrique 36 est adaptée à son rompre lors de la rupture de la partie sécable 42 par laquelle elle passe lors du déplacement de l'opercule 3c. Par exemple, la largeur de la piste électrique est de 150µm.

De façon connue, la piste électrique peut-être agencée sur la face de la plaque de circuit imprimé 30 en regard de l'élément mobile ou sur la face opposée ou encore dans l'épaisseur de la plaque de circuit imprimé 30.

En outre, l'épaisseur de la plaque de circuit imprimé 30 est comprise entre 0,1 mm et 2 mm, par exemple 0,8 mm dans notre cas, afin de permettre une rupture des parties sécables et le pliage de la charnière lors du déplacement de quelques millimètres de l'opercule 3csous l'effet d'une surpression.

De plus, les moyens de fixation sont adaptés à maintenir la portion périphérique de la plaque de circuit imprimé en place pendant le phénomène de désoperculation induit par une surpression dans le conteneur. Par exemple, les moyens de fixation comportent des rivets en plastique.

Selon un deuxième mode de réalisation d'un ensemble 20 comportant un accumulateur étanche 1 et un système de détection 24, l'accumulateur étanche 1 comporte en outre une membrane déformable 10 comme illustré en figure 3.

La membrane déformable 10 comprend une partie centrale 10b et une partie périphérique 10a et présente la forme d'un disque mais il est entendu que l'invention s'applique à d'autres formes compatibles avec la forme de l'opercule 3c du conteneur.

La limite entre la partie centrale 10b et la partie périphérique 10a de la membrane déformable 10 coïncide sensiblement avec la partie fragilisée 3b de la paroi du fond du conteneur 2 et d'autre part, que la partie périphérique 10a de la membrane coïncide sensiblement avec la partie périphérique 3a de la paroi du fond du conteneur.

Selon une variante afin de permettre une fonction de coupe-circuit de l'accumulateur étanche comme indiqué précédemment, la membrane déformable 10 est en matériau conducteur électrique pour permettre la conduction du courant entre les électrodes et l'opercule 3c. En outre, la partie centrale 10b est en contact électrique avec des électrodes de même polarité du faisceau électrochimique. Ce contact électrique peut être obtenu par soudage de la membrane avec la surface des extrémités des feuillards de ces électrodes non recouverte de matière active.

La surface de la membrane déformable peut comprendre des parties fragilisées, par exemple sous la forme d'un amincissement qui peut prendre différentes formes. L'épaisseur de l'amincissement est calculée pour provoquer une déchirure de l'amincissement lorsque la pression à l'intérieur du conteneur de l'accumulateur dépasse une valeur seuil prédéterminée, par exemple de 15 bars.

De plus, selon le mode de réalisation illustré sur la figure 3, l'accumulateur comporte une pièce de connexion 11 positionnée entre l'extrémité des électrodes d'une même polarité située au fond du conteneur 2 et la membrane déformable 10. La pièce de connexion 11 est souple et comprend :
- une partie de connexion 11 a destinée à être reliée électriquement au feuillard des électrodes dépassant d'une extrémité du faisceau électrochimique,
- une partie centrale 11b destinée à être fixée à la membrane déformable, et
- des lamelles flexibles, identiques reliant la partie centrale 11b à la partie de connexion 11a.

Par pièce souple, on entend une pièce se déformant lorsque la surpression pousse l'opercule 3c vers l'extérieur, la pièce de connexion 11 étant solidaire de l'opercule 3c.

Les lamelles sont spiralées, c'est-à-dire qu'elles ont une forme courbée qui s'éloigne progressivement de la partie centrale 11b. Les lamelles sont réparties régulièrement autour de la partie centrale 11b. Les lamelles peuvent être spiralées en tournant vers la droite ou vers la gauche.

De telles lamelles de cette forme permettent de rendre mobile la partie centrale par rapport à la partie de connexion en déplaçant la partie centrale selon un mouvement hélicoïdal dont l'axe passe par le centre de la partie centrale. Grâce au mouvement hélicoïdal effectué par la pièce de connexion, l'opercule 3c se trouve après déchirure de l'amincissement dans une position sensiblement parallèle à sa position avant rupture de l'amincissement. L'opercule est guidé lors de la déchirure de la partie fragilisée. Grâce au mouvement hélicoïdal de guidage effectué par la pièce de connexion sur l'opercule, la rupture de la partie fragilisée autour de l'opercule s'effectue totalement. En conséquence, l'opercule est assurément déconnecté de la partie périphérique. Ceci permet d'assurer que l'opercule ne soit plus en contact avec la partie périphérique. Par conséquent, ce deuxième mode de réalisation offre une bonne garantie de déconnexion électrique entre les électrodes d'une polarité et la borne de sortie de courant associée.

Le fonctionnement et l'avantage de la membrane sera détaillé dans la suite.

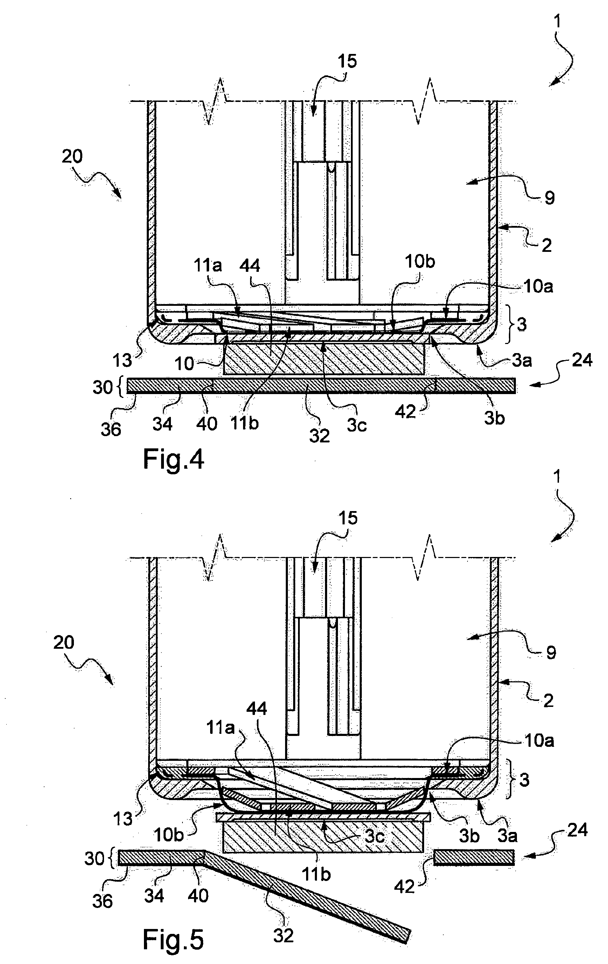

Selon un troisième mode de réalisation illustré sur la figure 4, le système de détection 24 est identique au second mode de réalisation et diffère en ce qu'il comporte en outre une pièce rigide ou entretoise 44 assurant le contact entre l'élément mobile ou opercule 3c du conteneur et la portion centrale 32 de la plaque de circuit imprimé 30.

Bien entendu, une telle pièce rigide ou entretoise 44 peut également être utilisée dans le cas du premier mode de réalisation.

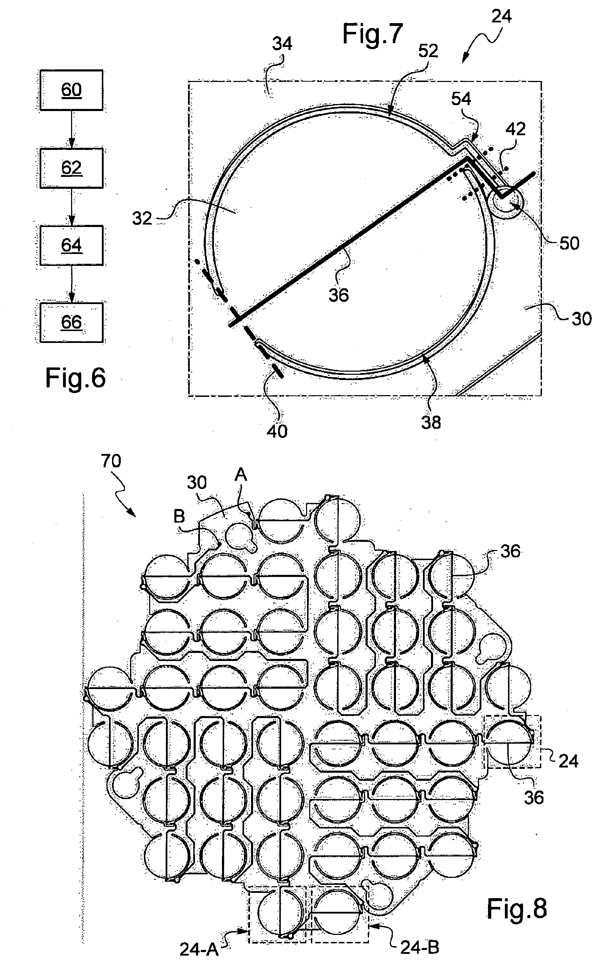

Il va maintenant être décrit le fonctionnement de l'accumulateur en cas d'augmentation de la pression interne en regard des figures 5 et 6 ainsi que le procédé de détection de désoperculation mis en oeuvre par un système de détection tel que décrit ci-dessus.

La surpression des gaz à l'intérieur du conteneur 2, en cas de dysfonctionnement de l'accumulateur étanche 1, crée sur l'élément mobile ou opercule 3c une force de poussée dirigée vers l'extérieur du conteneur 2. La force de poussée entraîne la rupture de la partie fragilisée, au cours d'une étape 60. La partie fragilisée, qui peut être un amincissement, est en effet conçue pour se rompre, c'est-à-dire se déchirer.

La force de poussée exercée sur l'opercule 3c conjuguée à la rupture de la partie fragilisée entraine l'opercule 3c en déplacement sur quelques millimètres, en 62.

L'opercule 3c en se déplaçant transmet cette force de poussée en exerçant une autre force de poussée dirigée selon son axe de déplacement sur la portion centrale 32 de la plaque de circuit imprimé 30 soit directement soit via l'entretoise 44 selon le mode de réalisation concerné, au cours de l'étape 64.

Cette mise sous contrainte du système de détection 24 par l'autre force de poussée sur la portion centrale 32 conjuguée au maintien en position de la partie périphérique, entraîne la rupture de la ou chaque partie sécable 42 et en particulier de la portion sécable 42 par laquelle la piste électrique 36 passe. Cette autre force de poussée entraîne également une déformation et un pliage de la charnière 40 du système de détection, en 66.

Il a été montré par la Demanderesse au cours de tests qu'une épaisseur de la plaque de circuit imprimé 30 sensiblement égale à 0,8 mm permet la rupture de la partie sécable 42 et le pliage de la charnière 40 lors d'une surpression de gaz dans le conteneur de 8 bars et donc la rupture du signal électrique entre les deux bornes polarisées situées aux extrémités de la piste électrique.

Bien entendu, le dimensionnement des différents éléments du système de détection et de l'accumulateur selon d'autres modes de réalisation par exemple pour obtenir une désoperculation à un autre seuil de pression à l'intérieur du conteneur est à la portée de l'homme du métier.

En outre et de manière facultative, la rupture de la piste électrique 30 peut déclencher un signal d'alerte, par exemple sonore ou visuel, informant de la rupture de la piste électrique 30.

Dans le cas du deuxième mode de réalisation, la présence de la membrane déformable 10 a pour effet de retenir les gaz émis par les réactions électrochimiques à l'intérieur du conteneur. Elle oblige ces gaz à exercer une pression homogène sur l'opercule jusqu'à sa déchirure complète. En l'absence de membrane, dès l'ouverture de l'opercule, les gaz s'évacueraient hors du conteneur de l'accumulateur et la pression sur l'opercule chuterait, ce qui ne permettrait pas une ouverture complète de l'opercule. La membrane déformable permet donc de maintenir le conteneur hermétiquement clos après déchirure de l'opercule. La rupture de la ou chaque portion sécable 42 et le pliage de la charnière 40 permette aisément de détecter visuellement si l'accumulateur étanche 1 a subit une désoperculation de son conteneur 2 suite à une surpression de gaz à l'intérieur de celui-ci.

En outre, cette détection résulte de la combinaison d'effets mécaniques et ne nécessite donc aucune source d'énergie électrique.

De plus, cette détection permet de déterminer si la chute de tension aux bornes d'un accumulateur étanche, comportant un dispositif de sécurité tel que celui représenté sur la figure 1 et décrit ci-avant, est due à une surpression ou non. En effet, lorsque l'accumulateur comporte un dispositif de sécurité assurant une fonction coupe circuit en cas de surpression, l'opercule n'est plus relié électriquement à la partie périphérique du fond du conteneur en cas de désoperculation. La conduction du courant entre la membrane déformable et la borne de sortie de courant est ainsi rompue. Néanmoins, une chute de tension aux bornes de l'accumulateur peut également intervenir même en l'absence de surpression, par exemple une soudure défectueuse... Dans ce cas, le système de détection permet de discriminer si la chute de tension est due à une surpression dans le conteneur de l'accumulateur.

De plus, si la piste électrique du système de détection est reliée en série avec une source d'alimentation et une résistance, la tension aux bornes de celle-ci reflètera l'état de la piste électrique qui agit alors comme un interrupteur. En effet, lorsqu'il n'y a pas désoperculation, la piste électrique est continue et l'interrupteur lui correspondant est fermé de sorte que la tension aux bornes de la résistance est égale à celle délivrée par la source de tension. Au contraire, après désoperculation, la piste électrique est rompue de sorte que l'interrupteur correspondant est ouvert et la tension aux bornes de la résistance est alors nulle instantanément à la rupture de la piste électrique.

La figure 7 illustre un mode de réalisation privilégié d'un système de détection de désoperculation 24 selon l'invention. La plaque de circuit imprimé 30 du système de détection 24 est fixée au conteneur 2 (non représenté) de l'accumulateur par des moyens de fixation 50 adaptés à maintenir la portion périphérique 34 de la plaque de circuit imprimé 30 en place pendant le phénomène de désoperculation induit par une surpression dans le conteneur. Dans l'exemple illustré, les moyens de fixation 50 comportent des rivets en plastique.

La portion centrale 32 de la plaque de circuit imprimé 30 comporte un disque 52 prolongé par une languette 54 par laquelle passe la piste électrique 36. L'axe longitudinal de la languette 54 est tangent au disque 52.

Le disque 52 est destiné à être en regard de l'opercule 3c et a sensiblement les mêmes dimensions que l'accumulateur 1.

La portion périphérique 34 est reliée à la portion centrale 32 par des moyens de liaison consistant en une charnière 40 et au moins une partie sécable 42.

La portion périphérique 34 est reliée en continuité de matière d'une part au disque 52 par la charnière 40 et d'autre part par la languette 54.

Dans l'exemple illustré en figure 7, la languette 54 comporte deux parties sécables 42 formées chacune par un pointillé de découpe et agencées chacune à proximité d'une extrémité de la languette. Chaque partie sécable 42 est adaptée à se rompre lors du déplacement de l'opercule 3c.

La piste électrique 36 relie la portion périphérique 34 à la portion centrale 32 en passant à la fois par la charnière 40 et par les deux parties sécables 42 de la languette.

La charnière 40 et le point de la languette 54 tangent au disque 52 sont diamétralement opposés. Dans ce cas, la charnière 40 et chaque partie sécable 42 sont espacées angulairement d'un angle sensiblement égal à 180° par rapport au centre géométrique du disque 52, c'est-à-dire d'un angle égal à 180° ± 20°.

De manière privilégiée, l'axe du pointillé de découpe formant la charnière 40 est perpendiculaire à l'axe de chacun des pointillés de découpe formant les parties sécables 42.

Un tel agencement permet une rupture plus efficace d'au moins une des parties sécables 42 du système de détection au niveau de la languette en exerçant une torsion au niveau de languette afin d'obtenir la déchirure d'au moins une des parties sécables.

Selon un autre mode de réalisation préféré du système de détection de désoperculation, les moyens de liaison consistent en une charnière 40 et une unique partie sécable 42. Dans ce cas, la charnière 40 et l'unique partie sécable 42 sont espacées angulairement d'un angle sensiblement égal à 180° par rapport au centre géométrique de la portion centrale 32 de manière avantageuse. Bien entendu, la charnière 40 et l'unique partie sécable 42 peuvent être espacées angulairement d'un angle inférieur à 180° par rapport au centre géométrique de la portion centrale.

L'invention a également pour objet un dispositif comportant au moins deux ensembles 20 tels que ceux décrits précédemment. Les accumulateurs étanches 1 sont connectés électriquement en parallèle et les systèmes de détection 24 sont connectés électriquement en série.

En outre, les plaques de circuit imprimé des systèmes de détection forment une unique plaque 30 commune dont les pistes électriques 36 sont reliées électriquement en série de manière à former une unique piste continue entre une première borne A et une seconde borne B.

Par exemple, le dispositif comporte un casier dans lequel sont agencés régulièrement les accumulateurs étanches 1 et l'unique plaque 30 est fixée et maintenue au casier par des rivets en plastique.

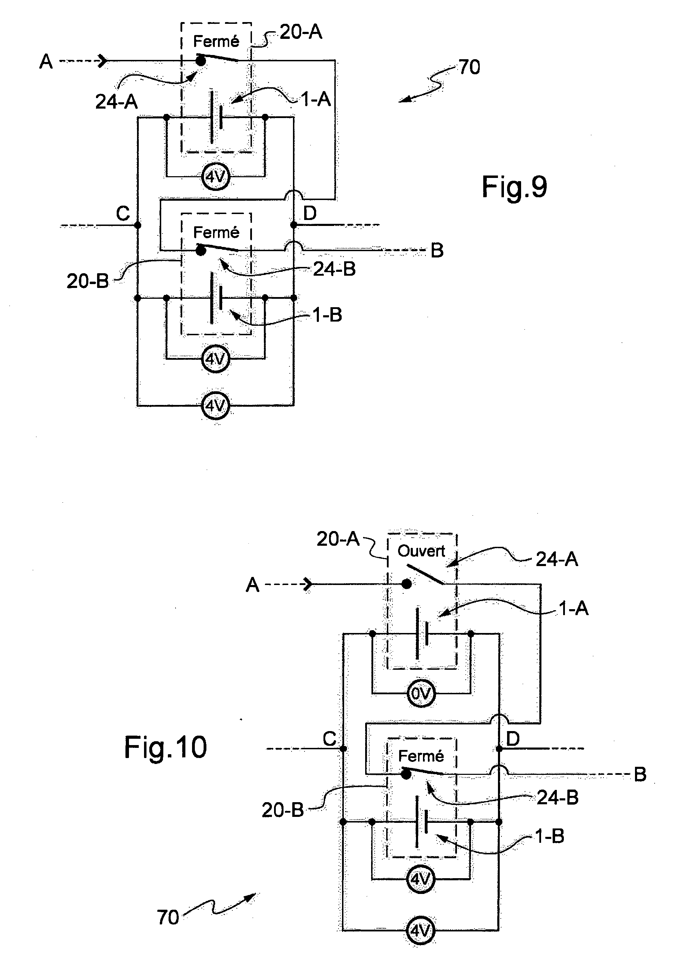

Un exemple d'un tel dispositif 70 est illustré sur la figure 8. Ce dispositif comporte 44 systèmes de détection connectés les uns aux autres électriquement en série via la piste électrique entre les première et seconde bornes A, B. Chaque système de détection 24 est agencé en regard de l'élément mobile ou opercule 3c d'un accumulateur étanche 1.La figure 9 est un schéma électrique équivalent à deux ensembles du dispositif de la figure 8 en utilisation dans des conditions nominales. Le premier et le second ensembles notés 20-A, 20-B comportent respectivement un accumulateur 1-A, 1-B et un système de détection 24-A, 24-B.

Les deux accumulateurs 1-A, 1-B sont connectés en parallèle et les deux systèmes de détection sont connectés électriquement en série.

Comme illustré sur la figure 9, dans des conditions nominales d'utilisation pour les deux accumulateurs 1-A, 1-B, la tension aux bornes de chaque accumulateur est non nulle, par exemple 4 V, et la tension entre la borne négative C commune aux accumulateurs et la borne positive D commune aux accumulateurs est également non nulle.

Chaque portion centrale d'un des systèmes de détection 24-A, 24-B est reliée respectivement à chaque portion périphérique puisqu'il n'y a aucune surpression dans les deux accumulateurs. La piste électrique est donc reliée continument entre les première et seconde bornes A et B.

La figure 10 illustre les mêmes ensembles que ceux de la figure 9, à l'exception du deuxième accumulateur 1-A qui ne fonctionne plus dans des conditions nominales et qui a subit une surpression de gaz à l'intérieur de son conteneur entraînant la désoperculation de celui-ci. Ceci est schématisé par une tension nulle aux bornes de cet accumulateur 1-A.

Les accumulateurs 1-A et 1-B étant reliés en parallèle, la tension entre la borne négative C commune aux accumulateurs et la borne positive D commune aux accumulateurs demeure non nulle puisque le premier accumulateur 1-B fonctionne normalement. Ainsi il n'est pas évident de constater une défaillance du deuxième accumulateur 1-A.

Néanmoins, le système de détection 24-A permet de détecter la désoperculation de l'accumulateur 1-A puisque la portion centrale 32-A n'est plus dans sa position initiale, c'est-à-dire reliée à la portion périphérique à la fois par la charnière et par la partie sécable.

On comprend aisément qu'un dysfonctionnement dû à une surpression, dans un dispositif 70 d'une pluralité d'ensembles 20, est aisément détecté par un tel ensemble de systèmes de détection 24.

En effet, en cas de surpression un signal d'alerte peut être émis comme indiqué précédemment et l'observation visuelle de la plaque de circuit imprimé permet alors de déterminer rapidement quel accumulateur a subi une surpression à l'intérieur de son conteneur.

Bien entendu, la présente invention n'est pas limitée aux exemples et aux modes de réalisation décrits et représentés, mais elle est susceptible de nombreuses variantes accessibles à l'homme du métier.

## Revendications

1. Système de détection de désoperculation (24) pour un accumulateur étanche (1), l'accumulateur étanche (1) comportant un conteneur (2) comprenant un opercule (3c) adapté pour se désolidariser du reste du conteneur et pour se déplacer lors d'une surpression de gaz à l'intérieur du conteneur (2) pour permettre la désoperculation de l'accumulateur étanche (1), le système de détection (24) comprenant une plaque de circuit imprimé (30) comprenant :
- une portion centrale (32) délimitée par un pourtour (38) destinée à être située en regard de l'opercule (3c),
- une portion périphérique (34) entourant la portion centrale (32), et reliée à ladite portion centrale (32) par des moyens de liaison consistant en :
◆ une charnière (40) adaptée pour se plier lors du déplacement de l'opercule (3c), et
◆ au moins une partie sécable (42) adaptée pour se rompre lors du déplacement de l'opercule (3c),
- une piste électrique (36) reliant la portion périphérique (34) à la portion centrale (32) en passant par la charnière (40) et par au moins une partie sécable (42), la piste électrique (36) étant adaptée à son rompre lors de la rupture de la partie sécable (42) lors du déplacement de l'opercule (3c).

2. Système de détection selon la revendication 1, dans lequel la portion centrale (32) et la portion périphérique (34) sont reliées en continuité de matière par les moyens de liaison sur une distance inférieure ou égale à 25 % du pourtour (38) de la portion centrale (32).

3. Système de détection selon la revendication 1 ou 2, dans lequel la charnière (40) et la ou les parties sécables (42) sont espacées angulairement d'un angle sensiblement égale à 180° par rapport au centre géométrique de la portion centrale (32).

4. Système de détection selon l'une quelconque des revendications 1 à 3, dans lequel un pointillé de découpe forme la charnière (40) selon une ligne moyenne droite reliant les deux extrémités de la charnière.

5. Système de détection selon l'une quelconque des revendications 1 à 4, dans lequel un pointillé de découpe forme la ou chaque partie sécable (42).

6. Système de détection selon la revendication 5 lorsqu'elle dépend de la revendication 4, dans lequel le pointillé de découpe formant la charnière (40) et le pointillé de découpe formant la partie sécable (42) sont perpendiculaires l'un par rapport à l'autre.

7. Système de détection selon l'une quelconque des revendications 1 à 6, dans lequel la forme de la portion centrale (32) est circulaire ou hexagonale.

8. Système de détection selon l'une quelconque des revendications 1 à 7, comportant une entretoise (44) destinée à assurer le contact entre l'opercule (3c) du conteneur (2) et la portion centrale (32) de la plaque de circuit imprimé (30).

9. Système de détection selon l'une quelconque des revendications 1 à 8, dans lequel l'épaisseur de la plaque de circuit imprimé (30) est comprise entre 0,1 et 2 mm.

10. Système de détection selon l'une quelconque des revendications 1 à 9, dans lequel la portion centrale (32) comporte un disque (52) prolongé par une languette (54), la languette comportant deux parties sécables (42) et étant reliée en continuité de matière à la partie périphérique (34), la piste électrique (36) passant par la languette (54).

11. Ensemble (20) comportant un accumulateur étanche (1) et un système de détection (24) selon l'une des revendications 1 à 10, dans lequel l'accumulateur étanche (1) comporte un conteneur (2) comprenant un élément mobile (28) adapté à se déplacer lors d'une surpression de gaz à l'intérieur du conteneur (2), la portion centrale (32) du système de détection (24) étant fixé en regard de l'élément mobile (28) du conteneur (2).

12. Ensemble (20) selon la revendication 11, dans lequel l'accumulateur étanche (1) comporte une membrane déformable (10) adaptée pour se déformer lors d'une surpression de gaz à l'intérieur du conteneur, cette déformation provoquant la désolidarisation de l'opercule (3c) du reste du conteneur.

13. Dispositif (70) comportant au moins deux ensembles (20) selon la revendication 11 ou 12 dans lequel les accumulateurs étanches (1) des ensembles sont connectés électriquement en parallèle, les systèmes de détection (24) des ensembles sont connectés électriquement en série, les plaques de circuit imprimés (30) des systèmes de détection formant une unique plaque commune.

14. Procédé de détection par un système de détection de désoperculation (24) pour un accumulateur étanche (1), l'accumulateur étanche (1) comportant un conteneur (2) comprenant un opercule (3c) adapté pour se désolidariser du reste du conteneur et pour se déplacer lors d'une surpression de gaz à l'intérieur du conteneur (2), le système de détection (24) étant selon l'une des revendications 1 à 10, le procédé comportant les étapes suivantes :
- déplacement mécanique (62) de l'opercule (3c) lors d'une surpression à l'intérieur du conteneur (2), et
- simultanément (66) pliage de la charnière (40) et rupture de la partie sécable (42) lors du déplacement de l'opercule (3c) entraînant une rupture de la piste électrique (30).

15. Procédé de détection de désoperculation selon la revendication 14, **caractérisé en ce que** la rupture de la piste électrique (30) déclenche un signal d'alerte informant de la rupture de la piste électrique (30).

## Patentansprüche

1. System zur Erkennung der Öffnung (24) eines Deckels für einen abgedichteten Akkumulator (1), wobei der abgedichtete Akkumulator (1) einen Behälter (2) aufweist, der einen Deckel (3c) umfasst, der dazu eingerichtet ist, sich bei einem Gasüberdruck im Inneren des Behälters (2) von dem Rest des Behälters zu lösen und sich zu bewegen, um die Öffnung des abgedichteten Akkumulators (1) zu ermöglichen, wobei das System zur Erkennung (24) eine gedruckte Leiterplatte (30) umfasst, welche umfasst:
- einen mittleren Abschnitt (32), der von einem Randbereich (38) begrenzt wird, der dazu bestimmt ist, sich gegenüber dem Deckel (3c) zu befinden;
- einen Umfangsabschnitt (34), der den mittleren Abschnitt (32) umgibt und mit dem mittleren Abschnitt (32) durch Verbindungsmittel verbunden ist, die aus Folgendem bestehen:
◆ einem Scharnier (40), das dazu eingerichtet ist, bei der Bewegung des Deckels (3c) umzuklappen, und
◆ mindestens einem brechbaren Teilabschnitt (42), der dazu eingerichtet ist, bei der Bewegung des Deckels (3c) zu brechen,
- eine elektrische Leiterbahn (36), die den Umfangsabschnitt (34) mit dem mittleren Abschnitt (32) verbindet und dabei über das Scharnier (40) und über mindestens einen brechbaren Teilabschnitt (42) verläuft, wobei die elektrische Leiterbahn (36) dazu eingerichtet ist, bei der Bewegung des Deckels (3c) beim Bruch des brechbaren Teilabschnitts (42) zu brechen.

2. System zur Erkennung nach Anspruch 1, wobei der mittlere Abschnitt (32) und der Umfangsabschnitt (34) durch die Verbindungsmittel auf einer Länge von 25 % oder weniger des Randbereichs (38) des mittleren Abschnitts (32) stoffschlüssig verbunden sind.

3. System zur Erkennung nach Anspruch 1 oder 2, wobei das Scharnier (40) und der oder die brechbare(n) Teilabschnitt(e) (42) in Bezug auf den geometrischen Mittelpunkt des mittleren Abschnitts (32) in einem Winkel, der im Wesentlichen gleich 180° ist, winkelbeabstandet sind.

4. System zur Erkennung nach einem der Ansprüche 1 bis 3, wobei eine Perforationslinie das Scharnier (40) entlang einer geraden Mittellinie bildet, welche die beiden Enden des Scharniers verbindet.

5. System zur Erkennung nach einem der Ansprüche 1 bis 4, wobei eine Perforationslinie den oder jeden brechbaren Teilabschnitt (42) bildet.

6. System zur Erkennung nach Anspruch 5, falls von Anspruch 4 abhängig, wobei die Perforationslinie, die das Scharnier (40) bildet, und die Perforationslinie, die den brechbaren Teilabschnitt (42) bildet, zueinander senkrecht sind.

7. System zur Erkennung nach einem der Ansprüche 1 bis 6, wobei die Form des mittleren Abschnitts (32) kreisförmig oder sechseckig ist.

8. System zur Erkennung nach einem der Ansprüche 1 bis 7, welches ein Abstandsstück (44) aufweist, das dazu bestimmt ist, den Kontakt zwischen dem Deckel (3c) des Behälters (2) und dem mittleren Abschnitt (32) der gedruckten Leiterplatte (30) sicherzustellen.

9. System zur Erkennung nach einem der Ansprüche 1 bis 8, wobei die Dicke der gedruckten Leiterplatte (30) zwischen 0,1 und 2 mm liegt.

10. System zur Erkennung nach einem der Ansprüche 1 bis 9, wobei der mittlere Abschnitt (32) eine Scheibe (52) aufweist, die durch eine Lasche (54) verlängert ist, wobei die Lasche zwei brechbare Teilabschnitte (42) aufweist und mit dem Umfangsabschnitt (34) stoffschlüssig verbunden ist, wobei die elektrische Leiterbahn (36) durch die Lasche (54) verläuft.

11. Anordnung (20), die einen abgedichteten Akkumulator (1) und ein System zur Erkennung (24) nach einem der Ansprüche 1 bis 10 aufweist, wobei der abgedichtete Akkumulator (1) einen Behälter (2) aufweist, der ein bewegliches Element (28) umfasst, das dazu eingerichtet ist, sich bei einem Gasüberdruck im Inneren des Behälters (2) zu bewegen, wobei der mittlere Abschnitt (32) des Systems zur Erkennung (24) gegenüber dem beweglichen Element (28) des Behälters (2) befestigt ist.

12. Anordnung (20) nach Anspruch 11, wobei der abgedichtete Akkumulator (1) eine verformbare Membran (10) aufweist, die dazu eingerichtet ist, sich bei einem Gasüberdruck im Inneren des Behälters zu verformen, wobei diese Verformung die Loslösung des Deckels (3c) von dem Rest des Behälters hervorruft.

13. Vorrichtung (70), welche mindestens zwei Anordnungen (20) nach Anspruch 11 oder 12 aufweist, wobei die abgedichteten Akkumulatoren (1) der Anordnungen elektrisch parallelgeschaltet sind und die Systeme zur Erkennung (24) der Anordnungen in Reihe geschaltet sind, wobei die gedruckten Leiterplatten (30) der Systeme zur Erkennung eine einzige gemeinsame Platte bilden.

14. Verfahren zur Erkennung durch ein System zur Erkennung der Öffnung (24) eines Deckels für einen abgedichteten Akkumulator (1), wobei der abgedichtete Akkumulator (1) einen Behälter (2) aufweist, der einen Deckel (3c) umfasst, der dazu eingerichtet ist, sich bei einem Gasüberdruck im Inneren des Behälters (2) von dem Rest des Behälters zu lösen und sich zu bewegen, wobei das System zur Erkennung (24) ein System nach einem der Ansprüche 1 bis 10 ist, wobei das Verfahren die folgenden Schritte umfasst:
- mechanisches Bewegen (62) des Deckels (3c) bei einem Überdruck im Inneren des Behälters (2), und
- gleichzeitiges Umklappen (66) des Scharniers (40) und Brechen des brechbaren Teilabschnitts (42) bei der Bewegung des Deckels (3c), was einen Bruch der elektrischen Leiterbahn (30) zur Folge hat.

15. Verfahren zur Erkennung der Öffnung eines Deckels nach Anspruch 14, **dadurch gekennzeichnet, dass** der Bruch der elektrischen Leiterbahn (30) ein Alarmsignal auslöst, das über den Bruch der elektrischen Leiterbahn (30) informiert.

## Claims

1. A venting detection system (24) for a sealed storage cell (1), the sealed storage cell (1) comprising a container (2) comprising a sealing cap (3c) adapted to be detached from the rest of the container and to move in the presence of excessive gas pressure within the container (2) to allow the venting of said sealed storage cell (1), the detection system (24) comprising a printed circuit board (30) comprising:
- a central portion (32) delimited by a circumference (38) designed to be situated facing said sealing cap (3c)
- a peripheral portion (34) surrounding the central portion (32) and connected to said central portion (32) by connecting means consisting of:
• a hinge (40) adapted to flex during movement of the sealing cap (3c), and
• at least one frangible portion (42) adapted to break upon movement of the sealing cap (3c)
- an electrical track (36) connecting said peripheral portion (34) to the central portion (32) through the hinge (40) and at least one frangible portion (42), the electrical printed track (36) being adapted to be broken through breaking of the frangible portion (42) upon movement of the sealing cap (3c).

2. The detection system according to claim 1, wherein the central portion (32) and the peripheral portion (34) are connected by continuity of material by the connecting means over a distance less than or equal to 25% of the circumference (38) of the central portion (32).

3. The detection system according to claim 1 or 2, wherein the hinge (40) and the frangible portion or portions (42) are angularly spaced by an angle substantially equal to 180 ° relative to the geometric center of the central portion (32).

4. The detection system according to any one of claims 1 to 3, wherein a line of cut out dots forms the hinge (40) following a mean straight line connecting the two ends of the hinge.

5. The detection system according to any one of claims 1 to 4, wherein a line of cut out dots forms the or each frangible portion (42).

6. The detection system according to claim 5 when dependent on claim 4, wherein the line of cut out dots forming the hinge (40) and the line of cut out dots forming the frangible portion (42) are perpendicular one with respect to the other.

7. The detection system according to any one of claims 1 to 6, wherein the shape of the central portion (32) is circular or hexagonal.

8. The detection system according to any one of claims 1 to 7, comprising a spacer (44) designed to ensure contact between the sealing cap (3c) of the container (2) and the central portion (32) of the printed circuit board (30).

9. The detection system according to any one of claims 1 to 8, wherein the thickness of the printed circuit board (30) is between 0.1 and 2 mm.

10. The detection system according to any one of claims 1 to 9, wherein the central portion (32) comprises a disc (52) extended by a tab (54), the tab having two frangible portions (42) and being connected through continuity of material to the peripheral portion (34), the electrical printed track (36) passing through the tab (54).

11. An assembly (20) comprising a sealed storage cell (1) and a detection system (24) according to one of Claims 1 to 10, wherein the sealed storage cell (1) comprises a container (2) comprising a movable member (28) adapted to move in the presence of gas overpressure inside the container (2), the central portion (32) of the detection system (24) being fixed facing the movable member (28) of the container (2).

12. The assembly (20) according to claim 11, wherein the sealed storage cell (1) comprises a deformable membrane (10) adapted to deform when there is excess pressure of gas within the container, deformation thereof causing a sealing cap (3c) to become detached from the rest of the container.

13. Apparatus (70) comprising at least two assemblies (20) of claim 11 or 12 wherein the sealed cells (1) of the assemblies are electrically connected in parallel, the detection systems (24) of the assemblies are electrically connected in series, the printed circuit boards (30) of the detection systems forming a single common board.

14. A detection method using a venting detection system (24) for a sealed storage cell (1), the sealed storage cell (1) comprising a container (2) comprising a sealing cap (3c) adapted to be detached from the rest of the container and move in the presence of gas overpressure inside the container (2), the detection system (24) being according to one of Claims 1 to 10, the method comprising the steps of:
- mechanical movement (62) of the sealing cap (3c) in the presence of excess pressure inside the container (2), and
- simultaneously (66) upon movement of the sealing cap (3c) folding of the hinge (40) and breaking of the frangible portion (42) thereby bringing about breaking of the electrical track (30).

15. The venting detection method of claim 14, **characterized in that** the breaking of the electrical track (30) triggers a warning signal informing of the breaking of the electrical printed track (30).
